# EUROPEAN PATENT APPLICATION

(11) **EP 4 067 850 A1**
(43) Date of publication of application: **05.10.2022**
(21) Application number: 21782430.9
(22) Date of filing: 09.02.2021
(51) Int. Cl.: G01L 5/00, G06F 3/041, G06K 9/00, G01L 1/14, G01L 9/00, H03K 17/955, H04R 1/10

(54) **PRESSURE DETECTION MODULE AND ELECTRONIC DEVICE**

(71) Applicant: SHENZHEN GOODIX TECHNOLOGY CO., LTD., Shenzhen, Guangdong 518045 (CN)
(72) Inventor: FENG, Lin, Shenzhen, Guangdong 518045 (CN)
(74) Representative: Sticht, Andreas
(86) International application number: PCT/CN2021/076377
(87) International publication number: WO 2022/170527

(57) **Abstract**

A pressure detection module and an electronic device are provided. The pressure detection module is arranged on an inner surface of a housing of the electronic device, and the pressure detection module includes: a first circuit board, a second circuit board, a force transmission member, a first electrode, and a second electrode; the first circuit board is fixedly connected to the second circuit board by a fixing member; the first electrode is fixed to the first circuit board, the second electrode is fixed to the second circuit board, and the first electrode is arranged opposite the second electrode, such that the first electrode and the second electrode form a capacitor; the force transmission member is located between a force input area of the housing and the first circuit board, and configured to transmit an external pressure received by the force input area to the first circuit board and drive the first electrode on the first circuit board to move in a direction toward the second electrode to change a capacitance between the first electrode and the second electrode, such that a pressure detection result of the external pressure is determined based on the capacitance change. The design, production and assembly processes of the pressure detection module of the present disclosure are simple and inexpensive.

## Description

### TECHNICAL FIELD

Embodiments of the present disclosure relate to the field of electronic technologies, and in particular to, a pressure detection module and an electronic device.

### BACKGROUND

Whether an electronic device, such as an earphone, is pressed may be detected by a pressure detection module installed therein, so as to perform operation control corresponding to the pressing. For example, whether the earphone is pressed is determined by the pressure detection module installed in the earphone, so as to control the earphone to play music.

In the related art, in order to install the pressure detection module inside the electronic device and realize the above function, the pressure detection module is usually required to be provided with a special bracket to support two electrodes of the pressure detection module. However, the internal space of the electronic device is usually very small, and the arrangement of a special bracket will result in complex production and assembly processes of the pressure detection module, thereby limiting the application and promotion of the pressure detection module in the electronic device.

Therefore, how to provide a pressure detection module with simple production and assembly processes has become a technical problem to be urgently solved.

### SUMMARY

In view of this, one of the technical problems to be solved by embodiments of the present utility model is to provide a pressure detection module and an electronic device, to solve a part or all of the technical problems existing in the prior art.

In a first aspect, the pressure detection module is arranged on an inner surface of a housing of the electronic device, the pressure detection module is arranged on an inner surface of a housing of the electronic device, and the pressure detection module includes:
a first circuit board, a second circuit board, a force transmission member, a first electrode, and a second electrode;
where the first circuit board is fixedly connected to the second circuit board by a fixing member; the first electrode is fixed to the first circuit board, the second electrode is fixed to the second circuit board, and the first electrode is arranged opposite the second electrode, such that the first electrode and the second electrode form a capacitor; and
the force transmission member is located between a force input area of the housing and the first circuit board, and configured to transmit an external pressure received by the force input area to the first circuit board and drive the first electrode on the first circuit board to move in a direction toward the second electrode to change a capacitance between the first electrode and the second electrode, such that a pressure detection result of the external pressure is determined based on the capacitance change.

In a second aspect, an embodiment of the present disclosure provides an electronic device. The electronic device is provided with the pressure detection module according to any one item of the first aspect inside the housing of the electronic device.

In the pressure detection module and the electronic device provided in embodiments of the present disclosure, the first circuit board is fixedly connected to the second circuit board by a fixing member; the first electrode is fixed to the first circuit board, the second electrode is fixed to the second circuit board, and the first electrode is arranged opposite the second electrode, such that the first electrode and the second electrode form a capacitor; and the force transmission member is located between a force input area of the housing and the first circuit board. When receiving an external pressure, the force input area of the housing transmits the external pressure to the first circuit board, such that the first circuit board has deformation to drive the first electrode on the first circuit board to move in a direction toward the second electrode, and determine a pressure detection result of the external pressure based on a capacitance change between the first electrode and the second electrode. Therefore, the pressure detection module of the embodiments of the present disclosure can achieve accurate pressure detection relying on the first circuit board provided with the first electrode and the second circuit board provided with the second electrode, in combination with a simple force transmission member, without the need for a bracket and other additional components, thereby simplifying the design, production and assembly processes of the pressure detection module with low costs.

### BRIEF DESCRIPTION OF THE DRAWINGS

Some specific embodiments of embodiments of the present disclosure will be described in detail below with reference to the accompanying drawings in an exemplary manner, instead of in a limiting manner. Identical reference numerals in the accompanying drawings represent identical or similar components or parts. Those skilled in the art should understand that these figures may not be drawn to scale. In the figures:

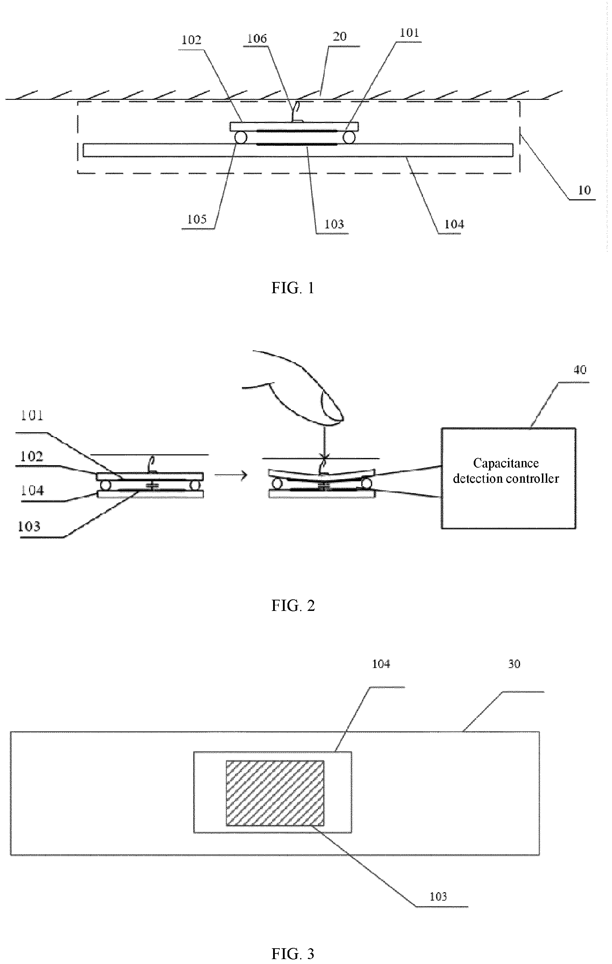

FIG. 1 is a schematic structural diagram of a pressure detection module provided in an embodiment of the present disclosure;
FIG. 2 is a schematic diagram of an operating principle of the pressure detection module provided in an embodiment of the present disclosure;

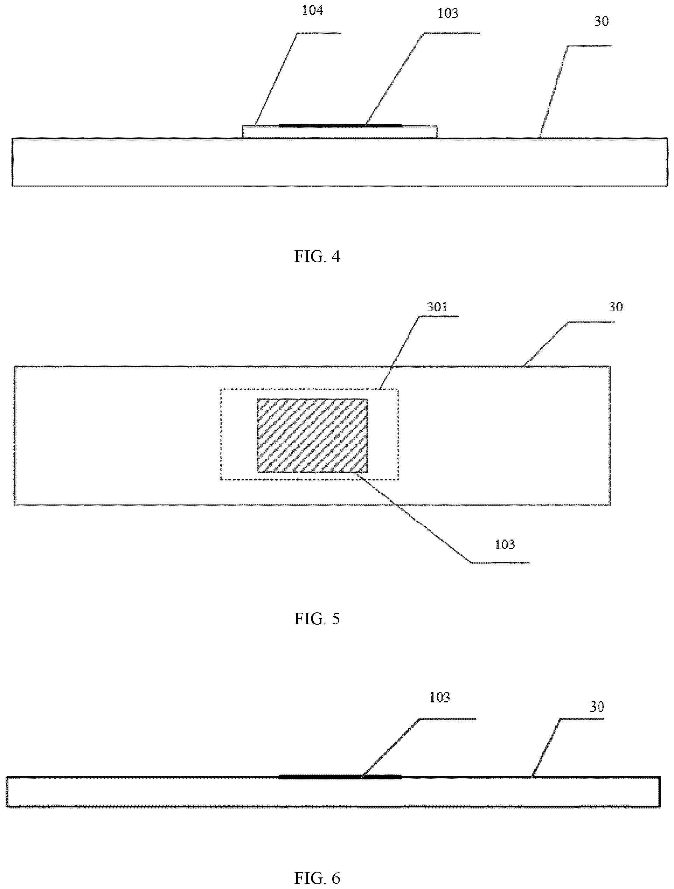

FIG. 3 is a top view of an example arrangement position of a first electrode in the pressure detection module provided in an embodiment of the present disclosure, and FIG. 4 is a section view of the example arrangement position of the first electrode in the pressure detection module provided in an embodiment of the present disclosure;
FIG. 5 is a top view of an example arrangement position of the first electrode in the pressure detection module provided in an embodiment of the present disclosure, and FIG. 6 is a section view of the example arrangement position of the first electrode in the pressure detection module provided in an embodiment of the present disclosure;

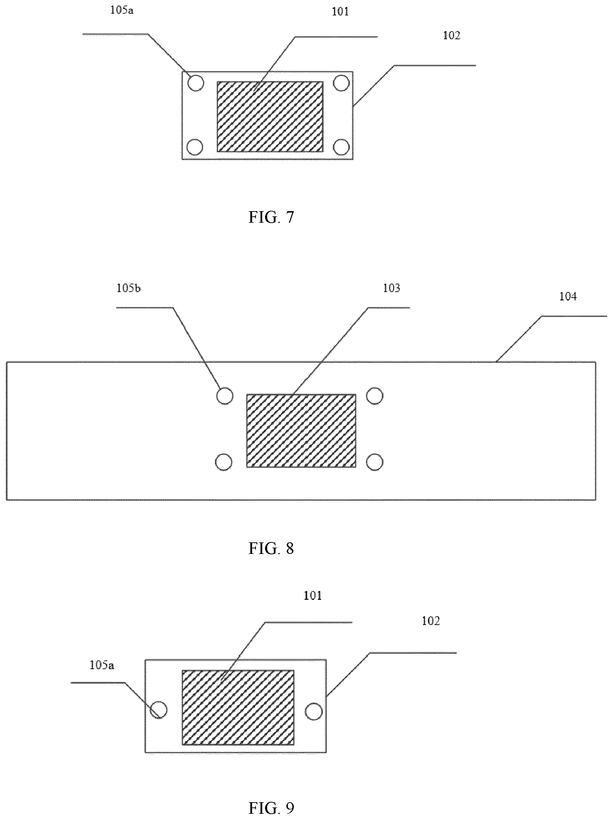

FIG. 7 is a schematic diagram of a layout position of a first welding member in the pressure detection module provided in an embodiment of the present disclosure, and FIG. 8 is a schematic diagram of a layout position of a second welding member in the pressure detection module provided in an embodiment of the present disclosure;

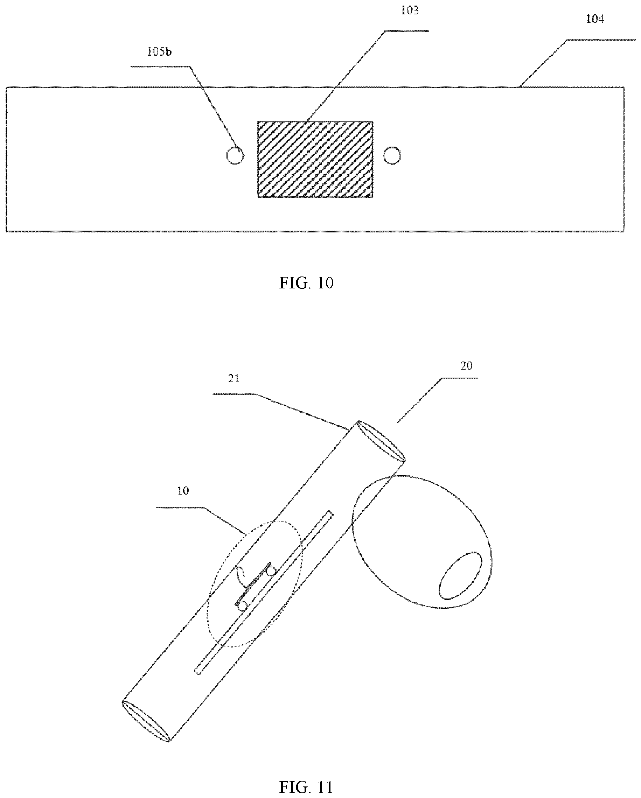

FIG. 9 is a schematic diagram of a layout position of the first welding member in the pressure detection module provided in an embodiment of the present disclosure, and FIG. 10 is a schematic diagram of a layout position of the second welding member in the pressure detection module provided in an embodiment of the present disclosure;

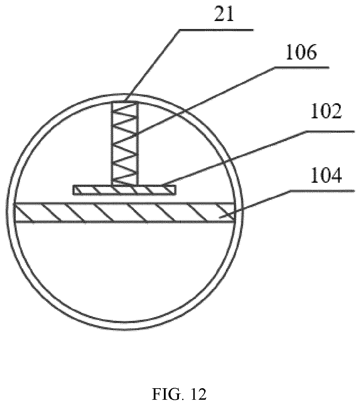

FIG. 11 is a schematic diagram of an electronic device with the pressure detection module provided in an embodiment of the present disclosure, and FIG. 12 is a sectional view of the electronic device with the pressure detection module provided in an embodiment of the present disclosure.

### DETAILED DESCRIPTION

The miniaturization and intelligentalization of electronic devices have become a development trend, and the experience of human-computer interaction of electronic devices has also attracted more and more users' attention. Generally, a pressure detection module may be provided inside an electronic device, and the pressure detection module detects whether the electronic device is pressed to control the electronic device to perform operation control corresponding to the pressing. Since the pressure sensing detection solution has the advantage of less accidental touch over the touch and tapping detection solution, the pressure detection module achieves better interactive experiences, and is increasingly favored by users. A capacitive pressure sensing solution and a resistive pressure detection solution are prevailing pressure detection solutions at present. However, the resistive pressure detection solution requires an additional metal strain gage or semiconductor pressure sensor, which is expensive, and can only be applied in high-end markets. The capacitive pressure detection solution in related technologies has high requirements for the design, production and assembly processes of the sensor, and is very difficult in production. For example, it is usually necessary to arrange a bracket in a narrow internal space of the electronic device to support two electrodes of the pressure detection module, such that the production and assembly processes of the pressure detection module are complex, thereby limiting the application and promotion of the pressure detection module in the electronic device. Further, even if the bracket is arranged, a capacitance detection electrode is extremely easily affected by relevant assembly process, thereby affecting the capacitance detection performance and the product yield.

In order to solve the above problems, embodiments of the present disclosure provide a pressure detection module and an electronic device. The specific implementations of the embodiments of the present utility model will be further described below with reference to the accompanying drawings of the embodiments of the present utility model.

An embodiment of the present disclosure provides a pressure detection module. As shown in FIG. 1, FIG. 1 is a structural diagram of a pressure detection module provided in an embodiment of the present disclosure. The pressure detection module 10 is arranged on an inner surface of a housing 20 of an electronic device, and the pressure detection module 10 includes: a first electrode 101, a second electrode 103, a first circuit board 102, a second circuit board 104, and a force transmission member 106.

The first circuit board 102 is fixedly connected to the second circuit board 104 by a fixing member 105; the first electrode 101 is fixed to the first circuit board 102, the second electrode is fixed to the second circuit board 104, and the first electrode 101 is arranged opposite the second electrode 102, such that the first electrode 101 and the second electrode 102 form a capacitor; and
the force transmission member 106 is located between a force input area of the housing and the first circuit board 102, and configured to transmit an external pressure received by the force input area to the first circuit board 102 and drive the first electrode 101 on the first circuit board 102 to move in a direction toward the second electrode 102 to change a capacitance between the first electrode 101 and the second electrode 102, such that a pressure detection result of the external pressure is determined based on the capacitance change.

In this embodiment, an air gap is formed between the first electrode and the second electrode by the fixing member 105, such that the first electrode and the second electrode form the capacitor, and a distance between the first electrode and the second electrode is equal to a height of the fixing member when the pressure detection module is not pressed.

In this embodiment, the force input area of the housing is an area of any shape, and the force input area may be provided with any mark to indicate that a user may apply a pressure in this area. Hence, when the force input area of the housing has deformation upon receiving the external pressure, the force transmission member 106 transmits a pressure to the first circuit board 102 along with the deformation of the housing, such that the first circuit board 102 drives the first electrode 101 to move closer to the second electrode 103. The first electrode 101 moves closer to the second electrode 103, such that the distance between the first electrode 101 and the second electrode 103 is reduced, such that the capacitance between the first electrode 101 and the second electrode 103 is changed, and the pressure detection result of the external pressure may be determined based on the capacitance change.

Specifically, as shown in FIG. 2, the first electrode 101 and the second electrode 103 form a pressure detection capacitor. When no external pressure is applied to the force input area of the housing, the pressure detection capacitor has a base capacitance value (Cbase). When a pressure is applied to the force input area of the housing, the force input area of the housing has deformation, such that the force transmission member 106 transmits the external pressure to the first circuit board 102, resulting in deformation of the first circuit board 102. The deformation of the first circuit board 102 reduces the distance between the first electrode 101 and the second electrode 103, thereby increasing the capacitance value of the pressure detection capacitor formed by the first electrode 101 and the second electrode 103, for example, increasing ΔC. In this case, the capacitance value of the pressure detection capacitor is Cbase+ΔC. A capacitance detection controller 40 is provided to detect the capacitance change between the first electrode 101 and the second electrode 103, and compare the capacitance change with a preset capacitance change threshold indicating pressing, thereby accurately identifying whether a press operation is specific to the force input area of the housing.

Therefore, the pressure detection module of the embodiment of the present disclosure can achieve accurate pressure detection by fixedly connecting the first circuit board to the second circuit board relying on the first circuit board provided with the first electrode and the second circuit board provided with the second electrode, in combination with a simple force transmission member, without the need for a bracket and other additional components, thereby simplifying the design, production and assembly processes of the pressure detection module with low costs. Further, these processes are customary processes, thereby reducing the influence of these processes on the product yield and consistency.

In this embodiment, a size of the first electrode 101 and a size of the second electrode 103 may be arranged based on a size of an internal cavity of the housing of the electronic device. For example, in a specific implementation of the embodiment of the present disclosure, a length of the first electrode 101 and a length of the second electrode 103 are both less than or equal to 5 mm, and a width of the first electrode 101 and a width of the second electrode 103 are both less than or equal to 1.5 mm. For example, the size of the first electrode 101 and the size of the second electrode 103 are 1.5 mm^{∗}5 mm, so as to make full use of the internal cavity of the electronic device (for example, earphone), and improve the sensitivity of pressure detection.

It should be understood that in other types of electronic devices, the first electrode 101 and the second electrode 103 may be adjusted based on a size of an installation space inside the electronic device, which is not limited in this embodiment.

In this embodiment, the first circuit board 102 may be a printed circuit board (PCB), or a flexible printed circuit (FPC).

In order to ensure the sensing sensitivity of the pressure detection module, in a specific implementation of the embodiment of the present disclosure, the first circuit board 102 has a preset thickness, and the preset thickness is arranged such that the first circuit board 102 will have deformation when receiving the external pressure transmitted by the force transmission member 106.

In a specific implementation of this embodiment, a thickness of the first circuit board is greater than or equal to 0.6 mm and less than or equal to 1.2 mm, for example, the preset thickness may be 0.8 mm, thereby ensuring that the first circuit board can reliably support the first electrode, and will have large deformation when receiving the external pressure transmitted by the force transmission member, and improving the sensitivity of pressure detection.

It should be understood that the thickness of the first circuit board 102 may be selected based on a size of the first circuit board 102. For example, when the size of the first circuit board 102 is larger, a relatively thicker first circuit board 102 may be selected. When the size of the first circuit board 102 is smaller, a relatively thinner first circuit board 102 may be selected, which is not limited in this embodiment.

In this embodiment, the second circuit board 104 may be a printed circuit board (PCB), or a flexible printed circuit (FPC). The second circuit board 104 may be any suitable circuit board that is arranged inside the housing of the electronic device and will not move within the electronic device when a user presses the housing of the electronic device. For example, the second circuit board 104 may be fixed to the housing of the electronic device, or the second circuit board 104 may be fixed to other components within the electronic device, which is not limited in this embodiment. The first circuit board 102 is fixedly connected to the second circuit board 104, such that the second circuit board 104 can support the first circuit board 102, and then can support the first electrode 101 and the second electrode 103. Therefore, it is not necessary to provide a bracket for supporting the pressure detection module within a narrow space of the electronic device, thereby simplifying the production and assembly difficulty of the pressure detection module, and greatly improving the production efficiency of the electronic device. In addition, customary inexpensive first circuit board and second circuit board may be used in the pressure detection module, such that the pressure detection module is also relatively inexpensive, and such that the pressure detection module may be directly installed as a whole within the electronic device, to further reduce the assembly process and reduce the yield and cost caused by the assembly process. Further, an existing circuit board of the electronic device may be reused for a circuit board where a capacitance detection electrode is located, thereby simplifying an electrical connection between the electrode and the capacitance detection circuit, and even the main control panel, reducing the arrangement of related electrical connectors, further reducing the space of the electronic device, and reducing the electrical interferences received by the electronic device.

Specifically, for example, the electronic device is an earphone and the pressure detection module is arranged in an earphone rod. After the pressure detection module is assembled, for the case where the earphone rod is non-detachable (i.e., a housing of the earphone rod is an integral whole, and is non-detachable), the pressure detection module may be inserted into the earphone rod from the tail of the earphone, thereby contributing to installation/assembly. For the case where the earphone rod is detachable (i.e., the earphone rod includes an upper housing and a lower housing), after the pressure detection module is installed in the lower housing (or the upper housing) of the earphone rod, the upper housing (or the lower housing) of the earphone rod closes on the lower housing (or the upper housing) of the earphone rod to assemble the pressure detection module within the earphone. In addition, an existing circuit board within the earphone may be reused for the circuit board where the capacitance detection electrode is located, thereby simplifying an electrical connection between the electrode and the capacitance detection circuit, and even the main control panel, reducing the arrangement of related electrical connectors, saving the internal space of the earphone, facilitating the installation of other electronic components, such as an antenna, of the earphone, and avoiding the interference of the pressure detection module with these electronic components.

In an implementation of the embodiment of the present disclosure, as shown in FIG. 3 and FIG. 4, the second circuit board 104 is arranged on a circuit motherboard 30 of the electronic device. Specifically, the second circuit board 104 may be fixedly connected to the circuit motherboard 30 by a bonding pad and an adhesive layer, such that it is neither necessary to fix the second circuit board 104 to the housing of the electronic device, nor necessary to arrange a supporting member for the second circuit board 104, thereby simplifying the assembly process, and reducing the space occupied by the pressure detection module in the electronic device.

Alternatively, in a specific implementation of the embodiment of the present disclosure, as shown in FIG. 5 and FIG. 6, the second circuit board 104 is the circuit motherboard 30 of the electronic device. The circuit motherboard 30 is fixedly connected to the housing, e.g., by a screw, glue, and a buckle. The circuit motherboard 30 is provided with a sensor area 301, and the second electrode 103 is provided in the sensor area 301. Specifically, a second surface of the second electrode 103 is fixed to the sensor area 301, and a first surface of the second electrode 103 is opposite to the first electrode 101, to form the pressure detection capacitor. The second electrode 103 is directly arranged on the circuit motherboard, thereby minimizing the occupied space in the electronic device.

In this embodiment, the first circuit board 102 is fixedly connected to the second circuit board 104 by the fixing member 105. Specifically, ends, corners, edges, or the like of the first circuit board 102 and the second circuit board 104 may be fixed by the fixing member 105, such that there is a preset distance between a second surface of the first electrode 101 and the first surface of the second electrode 103, to form the pressure detection capacitor.

In a specific implementation of the embodiment of the present disclosure, the first circuit board 102 is fixedly connected to the second circuit board 104 by a welding member. The welding member is a specific implementation of the fixing member. For example, a welding point may be provided at a border position of the first circuit board 102 or the first electrode 101, a bonding pad matching the welding point may be provided at a border position of the second circuit board 104 or the second electrode 102, and the welding point and the bonding pad are welded together using a surface mounted technology (SMT), thereby fixing the first circuit board 102 and the second circuit board 104 as a whole. The position matching of the welding point and the bonding pad can ensure that the first electrode 101 is directly facing the second electrode 103 during assembly, thereby improving the assembly accuracy of the pressure detection module.

For example, in a specific implementation, welding points are provided at four corners of the first electrode 101, bonding pads matching the welding points are provided at four corners of the second circuit board 102, and the first circuit board 102 and the second circuit board 104 are fixed as a whole by the welding points and the bonding pads. A welding point is provided at each corner of the first circuit board 102. When the force transmission member 106 transmits the same external pressure to the first circuit board 102, the first circuit board 102 may have large deformation in a direction toward the second circuit board 104 with the four corners of the first electrode 101 as supporting points, thereby improving the sensitivity of pressure detection.

For another example, in a specific implementation, welding points are provided at two opposite ends of the first electrode 101, bonding pads matching the welding points are provided at two opposite ends of the second electrode 103, and the first electrode 101 and the second electrode 103 are fixed as a whole by the bonding pads and the welding points, thereby fixing the first circuit board 102 and the second circuit board 104 as a whole. For example, a welding point is provided at each corner of the first circuit board 102. When the force transmission member 106 transmits the same external pressure to the first circuit board 102, the first circuit board 102 may have large deformation in a direction toward the second circuit board 104 with two ends of the first electrode 101 as supporting points, thereby improving the sensitivity of pressure detection.

It should be understood that the welding points and the bonding pads may be arranged on the first circuit board 103 and the second circuit board 104 respectively, and the specific arrangement positions and number may be similar to those of the welding points and the bonding pads arranged on the first electrode 101 and the second electrode 102. In order to avoid repetitive descriptions, detailed description will not be provided here.

Preferably, in one implementation of the present disclosure, a welding point is provided on the first circuit board 102 around an outer periphery of the first electrode 101, and a bonding pad is provided on the second circuit board 104 at a position matching the welding point around an outer periphery of the second electrode 103, thereby minimizing the size of the first circuit board 102 and a size of the second circuit board 104, and improving the sensitivity of pressure detection.

For example, as shown in FIG. 7 and FIG. 8, the number of welding points 105a is 4, and the number of bonding pads 105b is 4. The 4 welding points 105a are arranged on the first circuit board 102 at four corners closer to the first electrode 101 respectively. Accordingly, the 4 bonding pads 105b are arranged on the second circuit board 104 at four corners closer to the second electrode 103 respectively, and the 4 bonding pads correspond to the 4 welding points, respectively. In the examples of FIG. 6 and FIG. 7, when the force transmission member transmits the same external pressure to the first circuit board 102, the first circuit board 102 may have large deformation in a direction toward the second circuit board 104, thereby minimizing the size of the first circuit board 102 and the size of the second circuit board 104, and improving the sensitivity of pressure detection.

For another example, as shown in FIG. 9 and FIG. 10, the number of welding points 105a is 2, the number of bonding pads 105b is 2, the 2 welding points 105a are arranged on the first circuit board at two opposite ends closer to the first electrode respectively, and the 2 bonding pads 105b are arranged on the second circuit board at two opposite ends closer to the second electrode. Specifically, the 2 welding points are closer to two ends having shorter side lengths of the first electrode, and the 2 bonding pads are closer to two ends having shorter side lengths of the second electrode. The 2 bonding pads correspond to the 2 welding points respectively. When the force transmission member 106 transmits the same external pressure to the first circuit board 102, the first circuit board 102 may have large deformation in a direction toward the second circuit board 104 with 2 ends having shorter lengths as supporting points, thereby minimizing the size of the first circuit board 102 and the size of the second circuit board 104, and improving the sensitivity of pressure detection.

It should be understood that the number and positions of the welding points 105a and the bonding pads 105b described above are merely examples. In other implementations, more welding points 105a and bonding pads 105b may be provided as needed, which is not limited in this embodiment.

In this embodiment, an air gap is formed between the first electrode and the second electrode by the bonding pad, such that the first electrode and the second electrode form a capacitor, and a distance between the first electrode and the second electrode is equal to a height of the bonding pad when the pressure detection module is not pressed. In this embodiment, the first electrode and the second electrode are reliably supported by the bonding pads and welding points with a simple process, and the first electrode and the second electrode are separated by a certain distance, resulting in electrical insulation therebetween, such that the first electrode and the second motor form an electrode for pressure detection.

Since the distance between the first electrode and the second electrode is equal to the height of the bonding pad, the distance between the first electrode and the second electrode may be adjusted by controlling the height of the bonding pad. For example, during SMT, a thickness of solder paste coated on the bonding pad 105b is controlled by controlling a size of a steel mesh, thereby controlling the height of the bonding pad, and further controlling the distance between the first electrode 101 and the second electrode 103 with a simple process.

It should be understood that the distance between the first electrode 101 and the second electrode 103 may be an air gap, or may be filled with a soft filler, which is not limited in this embodiment.

In a specific implementation of the present disclosure, the distance between the first electrode 101 and the second electrode 103 is greater than or equal to 0.1 mm and less than or equal to 0.4 mm, such that the capacitor formed by the first electrode 101 and the second electrode 103 can reflect the external pressure and minimize the distance between the first electrode 101 and the second electrode 103, thereby occupying a smaller internal space of the electronic device. This can ensure that the detected pressure signal reaches a certain csemaphore, so as to avoid affecting the accuracy of the detected pressure because no signal is detected or a weak signal is detected, and can further reduce the volume and thickness of the pressure detection module.

In a specific implementation of the embodiment of the present disclosure, the fixing member 105 includes at least two first adhering members having a preset height. The first adhering member may be gelatin, or may be a double-sided adhesive tape with adhesive force on upper and lower sides, or the like.

In a specific implementation of the present disclosure, the first adhering member is provided between the first circuit board 102 and the second circuit board 104 to fix the ends of the first circuit board 102 and the second circuit board 104. The preset height is arranged such that the first electrode 101 and the second electrode 103 form the capacitor. Preferably, the first adhering member is provided between the first circuit board 102 and the second circuit board 104 around an outer periphery of the first electrode 101 and the second electrode 103. For example, the first adhering member is provided between the first circuit board 102 and the second circuit board 104 around an outer periphery of the first electrode 101 and the second electrode 103.

It should be understood that the first adhering member may be provided between the first electrode 101 and the second electrode 103 to fix the ends of the first electrode 101 and the second electrode 103. In this embodiment, the number and arrangement positions of the first adhering members are similar to those of the welding points 105a. In order to avoid repetitive descriptions, detailed description will not be provided here.

It should be understood that the distance between the first electrode 101 and the second electrode 103 may be adjusted by adjusting the preset height of the first adhering member, such that the distance between the first electrode 101 and the second electrode 103 can ensure that the detected pressure signal reaches a certain csemaphore, so as to avoid affecting the accuracy of the detected pressure because no signal is detected or a weak signal is detected, and can further reduce the volume and thickness of the pressure detection module.

In this embodiment, the force transmission member 106 is located between the force input area of the housing and the first circuit board, and is specifically arranged between an inner surface of the force input area of the housing and a surface of the first circuit board 102 away from the first electrode 101, to accurately transmit the external pressure applied to the force input area of the housing 20 to the first circuit board 102. For ease of description, hereinafter, a surface on the first circuit board 102 provided with the first electrode 101 is referred to as a first surface of the first circuit board 102, and a surface on the first circuit board 102 away from the first electrode 101 is referred to as a second surface of the first circuit board 102. This embodiment does not limit the manner of arranging the force transmission member between the force input area of the housing and the first circuit board. For example, both ends of the force transmission member 106 may be fixed to the first circuit board and the inner surface of the force input area of the housing respectively by, e.g., adhesion or welding.

Alternatively, in another specific implementation of the present disclosure, one end of the force transmission member 106 is fixed to the first circuit board, and the other end of the force transmission member abuts against the force input area of the housing. Specifically, one end of the force transmission member 106 may be fixed to the second surface of the first circuit board 102 by, e.g., adhesion or welding, while the other end abuts against the inner surface of the force input area of the housing, and is rigidly connected to the inner surface of the force input area of the housing, such that the pressure detection module may be installed as a whole within the housing of the electronic device, which is convenient for installation and/or assembly, and is suitable for the case where the housing of the electronic device is detachable or non-detachable.

Specifically, for example, the electronic device is an earphone and the pressure detection module is arranged in the earphone rod. The force transmission member abuts against the housing of the earphone rod, instead of a movable housing of the earphone rod, such that the pressure detection module, after being assembled, may be inserted into the earphone rod as a whole, thereby contributing to installation/assembly. In addition, since it is not necessary to fix the force transmission member to the inner surface of the housing of the earphone rod, the pressure detection module, after being assembled, may be inserted into the earphone rod as a whole (for example, from the tail of the earphone), or the upper housing and the lower housing of the earphone rod may be closed after the pressure detection module is assembled, and the pressure detection module may be arranged within the earphone rod, such that the pressure detection module is suitable for the case where the earphone rod is non-detachable (i.e., the housing of the earphone rod is an integral whole, and is non-detachable) and the case where the earphone rod is detachable (i.e., the earphone rod includes the upper housing and the lower housing).

In a specific implementation of the present disclosure, the force transmission member 106 is located at a center position of the force input area, i.e., a position where the force transmission member 106 contacts with the force input area of the housing is the center position of the force input area. Therefore, when the force input area of the housing has deformation upon receiving the external pressure, the center position of the force input area has largest deformation, thereby maximizing the transmission of the received external pressure to the first circuit board 102.

In an embodiment of the present disclosure, the force transmission member 106 is an elastic member, and the elastic member is in a compressed state when the force input area is not subjected to a force, such that the elastic member abuts by tension against the force input area of the housing, and such that the force transmission member 106 can absorb the assembly tolerance and/or material tolerance when the pressure detection module is assembled with the housing of the electronic device, thereby further improving the accuracy and consistency of pressure detection.

For example, in the assembly design, the distance between the second surface of the first circuit board 102 in the pressure detection module (i.e., the surface where the force transmission member 106 is located) and the force input area of the housing should be 1.5 mm. However, in the actual assembly process, due to the existence of the assembly tolerance and/or material tolerance, the distance between the second surface of the first circuit board 102 and the force input area of the housing is only 1.2 mm. In this case, due to a certain elastic strength of the force transmission member 106, the force transmission member 106 may be installed between the second surface of the first circuit board 102 and the force input area of the housing without causing deformation of the first circuit board 102, i.e., absorbing the assembly tolerance and/or material tolerance of the pressure detection module and the housing of the electronic device.

It should be understood that the force transmission member 106 should also have certain rigidity, thereby ensuring that the external pressure applied by a user to the force input area of the housing is accurately transmitted to the first circuit board 102.

In order to achieve simpler and inexpensive installation, the force transmission member 106 may be an elastic slice, a spring, a thimble, or a silicone pad. It should be understood that merely example description is provided here. In other embodiments, the force transmission member 106 may be other components with similar elasticity and rigidity, which is not limited in this embodiment.

An embodiment of the present disclosure provides an electronic device. The pressure detection module provided in any one of the above embodiments is provided inside the housing of the electronic device.

In this embodiment, the electronic device may be any suitable electronic device that requires pressure detection. For example, the electronic device may be an earphone, such as a True Wireless Stereo (TWS) earphone, a neck earphone, or a headphone. For another example, the electronic device may also be a wearable device, such as a smart watch, or smart glasses. For another example, the electronic device may also be an electric toothbrush, a remote controller, an electronic cigarette, or the like.

The pressure detection module in this embodiment may be arranged at any suitable position inside the housing of the electronic device. For example, when the electronic device is an earphone, the pressure detection module may be located in the earphone rod. When the electronic device is smart glasses, the pressure detection module may be located in a rod connected to eyeglass on the smart glasses. It should be understood that merely example description is provided here, which is not limited in this embodiment.

For ease of understanding, the installation position and assembly process of the pressure detection module will be described in detail below with reference to FIG. 11 and FIG. 12, where the electronic device is, e.g., an earphone. In this example, the pressure detection module 10 is arranged inside the housing of the earphone rod 21.

Specifically, as shown in FIG. 11 and FIG. 12, a first surface of the first electrode is fixed to the first circuit board 102, the second surface of the first electrode is opposite to the first surface of the second electrode, and the first electrode and the second electrode form a capacitor. The second surface of the second electrode is fixed to the second circuit board 104. The first circuit board 102 is fixedly connected to the second circuit board 104 by the fixing member 105. The force transmission member 106 is arranged on the surface of the first circuit board 102 away from the first electrode. The above pressure detection module, after being assembled, may be directly inserted into the earphone rod from the tail of the earphone, such that the force transmission member 106 is arranged between the first circuit board and the inner surface of the force input area of the housing of the earphone rod. For a cover-removable earphone, after the pressure detection module is installed in the lower housing (or the upper housing) of the earphone rod, the upper housing (or the lower housing) of the earphone rod closes on the lower housing (or the upper housing) of the earphone rod to ensure rigid connection between the force transmission member and the inner surface of the housing of the rod.

The above installation and assembly processes are customary production processes with simple assembly and few steps, thereby greatly improving the production efficiency. Further, the pressure detection module can achieve accurate pressure detection by providing two electrodes relying on the first circuit board and the second circuit board, in combination with a simple force transmission member, without the need for a bracket and other additional components, thereby simplifying the design, production and assembly processes of the pressure detection module. Still further, inexpensive first circuit board and second circuit board are used in the pressure detection module, such that the pressure detection module is also relatively inexpensive.

The embodiments in the present specification are described progressively, identical or similar portions between the embodiments may be mutually referred to, and differences of each embodiment from other embodiments are mainly described in the embodiment. In particular, system embodiments are substantially similar to method embodiments, and therefore are relatively simply described. A part of description of the method embodiments may be referred to for relevant details.

The above description merely provides embodiments of the present disclosure, and is not intended to limit the present disclosure. For those skilled in the art, the present disclosure may have various modifications and alterations. Any modification, equivalent replacement, improvement, and the like made within the spirit and principles of the present disclosure should be encompassed within the scope of the appended claims of the present disclosure.

## Claims

1. A pressure detection module, being applied to an electronic device, wherein the pressure detection module is arranged on an inner surface of a housing of the electronic device, and the pressure detection module comprises:
a first circuit board, a second circuit board, a force transmission member, a first electrode, and a second electrode;
wherein the first circuit board is fixedly connected to the second circuit board by a fixing member; the first electrode is fixed to the first circuit board, the second electrode is fixed to the second circuit board, and the first electrode is arranged opposite the second electrode, such that the first electrode and the second electrode form a capacitor; and
the force transmission member is located between a force input area of the housing and the first circuit board, and configured to transmit an external pressure received by the force input area to the first circuit board and drive the first electrode on the first circuit board to move toward the second electrode to change a capacitance between the first electrode and the second electrode, such that a pressure detection result of the external pressure is determined based on the capacitance change.

2. The pressure detection module according to claim 1, wherein the force transmission member is located at a center position of the force input area.

3. The pressure detection module according to claim 1, wherein one end of the force transmission member is fixed to the first circuit board, and the other end of the force transmission member abuts against the force input area of the housing.

4. The pressure detection module according to any one of claims 1 to 3, wherein the force transmission member is an elastic member, and the elastic member is in a compressed state when the force input area is not subjected to a force, such that the elastic member abuts by tension against the force input area of the housing.

5. The pressure detection module according to claim 4, wherein the force transmission member is an elastic slice, a spring, a thimble, or a silicone pad.

6. The pressure detection module according to any one of claims 1 to 3, wherein the first circuit board is fixedly connected to the second circuit board by a welding member.

7. The pressure detection module according to claim 6, wherein a welding point is provided on the first circuit board around an outer periphery of the first electrode, a bonding pad matching the welding point is provided on the second circuit board around an outer periphery of the second electrode, and the first circuit board and the second circuit board are fixed as a whole by the welding point and the bonding pad.

8. The pressure detection module according to claim 6, wherein welding points are provided at four corners of the first electrode or the first circuit board, and bonding pads matching the welding points are provided at four corners of the second circuit board or the second electrode; or,
welding points are provided at two opposite ends of the first electrode or the first circuit board, and bonding pads matching the welding points are provided at two opposite ends of the second circuit board or the second electrode; and
the first circuit board and the second circuit board are fixed as a whole by the welding points and the bonding pads.

9. The pressure detection module according to claim 8, wherein an air gap is formed between the first electrode and the second electrode by the bonding pad, such that the first electrode and the second electrode form a capacitor, and a distance between the first electrode and the second electrode is equal to a height of the bonding pad when the pressure detection module is not pressed.

10. The pressure detection module according to claim 1, wherein the fixing member comprises at least two first adhering members having a preset height, and the first adhering member is arranged between the first circuit board and the second circuit board, for fixing the ends of the first circuit board and the second circuit board, or the first adhering member is arranged between the first electrode and the second electrode, for fixing the ends of the first electrode and the second electrode; and
the preset height is set such that the first electrode and the second electrode form a capacitor.

11. The pressure detection module according to claim 10, wherein the first adhering member is provided between the first circuit board and the second circuit board around an outer periphery of the first electrode and the second electrode.

12. The pressure detection module according to any one of claims 1 to 3, wherein the second circuit board is a circuit motherboard of the electronic device, or
the second circuit board is fixed to the circuit motherboard of the electronic device.

13. The pressure detection module according to any one of claims 1 to 3, wherein a distance between the first electrode and the second electrode is greater than or equal to 0.1 mm, and is less than or equal to 0.4 mm.

14. The pressure detection module according to any one of claims 1 to 3, wherein a thickness of the first circuit board is greater than or equal to 0.6 mm, and less than or equal to 1.2 mm.

15. The pressure detection module according to claim 14, wherein the thickness of the first circuit board is 0.8 mm.

16. The pressure detection module according to any one of claims 1 to 3, wherein a length of the first electrode and the second electrode are both less than or equal to 5 mm, and a width of the first electrode and the second electrode are both less than or equal to 1.5 mm.

17. An electronic device, being provided with the pressure detection module according to any one of claims 1 to 16 inside the housing of the electronic device.

18. The electronic device according to claim 17, wherein the electronic device is an earphone, and the pressure detection module is arranged inside a housing of a rod of the earphone.
